# EUROPEAN PATENT SPECIFICATION

(11) **EP 0 264 892 B1**
(45) Date of publication and mention of the grant of the patent: **10.02.1993**
(21) Application number: 87115294.8
(22) Date of filing: 19.10.1987
(51) Int. Cl.: H01L 23/42, H01L 23/36, F28F 23/00

(54) **Cooling objects, for example semiconductor devices**
Kühlung von Objekten, zum Beispiel Halbleiteranordnungen
Refroidissement d'objets, par example de dispositifs semi-conducteurs

(30) Priority: 20.10.1986 JP 248801/86
(43) Date of publication of application: 27.04.1988
(73) Proprietor: FUJITSU LIMITED, Kawasaki-shi, Kanagawa 211 (JP)
(72) Inventor: Natori, Katsuhide FUJITSU LTD. Kosugi Fujitsu B., Kawasaki-shi Kanagawa 211 (JP); Watanabe, Isao FUJITSU LTD. Kosugi Fujitsu B., Kawasaki-shi Kanagawa 211 (JP); Katsuyama, Koji FUJITSU LTD. Kosugi Fujitsu B., Kawasaki-shi Kanagawa 211 (JP); Kawamura, Isao FUJITSU LTD. Kosugi Fujitsu B., Kawasaki-shi Kanagawa 211 (JP); Yamamoto, Haruhiko FUJITSU LTD. Kosugi Fujitsu B., Kawasaki-shi Kanagawa 211 (JP); Nagai, Takeshi FUJITSU LTD. Kosugi Fujitsu B., Kawasaki-shi Kanagawa 211 (JP)
(74) Representative: Sunderland, James Harry

(56) References cited:
- EP-A- 0 032 178
- US-A- 3 852 803
- US-A- 4 446 916
- PATENT ABSTRACTS OF JAPAN, vol. 8, no. 36 (E-227)[1473], 16th February 1984; & JP-A-58 196 041
- Idem

## Description

The present invention relates to the cooling of objects, for example semiconductor devices.

Recently, with a view to improving the processing ability of information processing systems, transistor devices used in the systems have been miniaturised to an extreme degree. Accordingly, elements in semiconductor devices have been miniaturised to an extreme degree: in other words, the number of electronic elements mounted on a semiconductor device has greatly increased, as exemplified by advanced semiconductor devices such as LSI ( Large Scale Integration) devices and VLSI (Very Large Scale Integration) devices. However, the realisation of reduction in size of a semiconductor device, in other words realisation of higher packing density for a semiconductor device, results in the generation of a large amount of heat from the semiconductor device.

It has become impossible to keep the operating temperature of a semiconductor device down to a maximum allowable in use, using only conventional air cooling for the device. The heating value per second of a semiconductor device is, for example, about 4 Watts even in a maximum, and this can increase up to as much as 10 Watts in the case of a VLSI. Therefore, to cool semiconductor devices it has become necessary to employ liquid cooling in place of conventional air cooling.

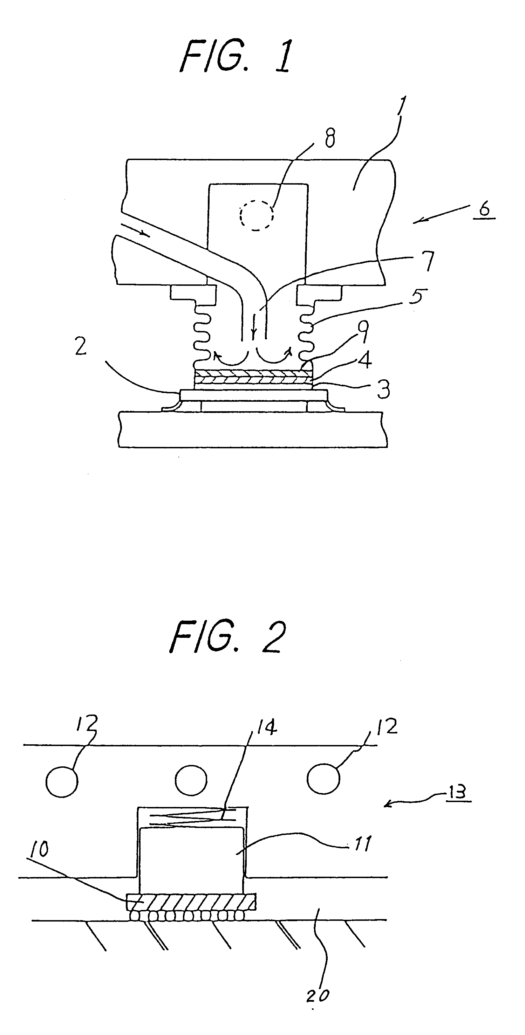

Many kinds of liquid cooling units or structures have been proposed. For instance, Fig. 1 shows a liquid cooling unit for a flat package type semiconductor device, and Fig. 2 shows a liquid cooling structure for a flip chip type semiconductor device. Such a liquid cooling unit or structure may be applied to other types of semiconductor device.

Fig. 1 illustrates the mounting of a liquid cooling unit 6 onto a flat package type semiconductor device 2 through an elastic heat conducting body 4 and a heat transfer plate 3 (made of, for example, alumina) provided on the flat package type semiconductor device 2. The liquid cooling unit 6 comprises a cooling body 1, a bellows 5 made of metal or plastic, a heat conducting plate 9 connected to the bellows 5, a nozzle 7 and a water drain port 8. The heat conducting plate 9 is thermally connected with the heat transfer plate 3 through the elastic heat conducting body 4.

In Fig. 1, the nozzle 7 injects cooling water into a chamber formed by the bellows 5 for cooling the heat conducting plate 9 so that heat generated by the flat package type semiconductor device 2 is transferred to the cooling body 1, then the cooling water injected into the chamber is caused to flow out from the water drain port 8, transferring heat from the heat conducting plate 9. Usually, the cooling temperature can be controlled by changing temperature of the cooling water.

The elastic heat conducting body is made of silicon rubber, in which ceramic powder is mixed, for providing that the body has a good heat conducting characteristic and good contact with both the heat conducting plate 9 and the heat transfer plate 3, using pressure due to the elasticity of the bellows 5.

Fig. 2 illustrates a cooling structure for a flip chip type semiconductor device 10 utilising a metal block (made of, for example, aluminium) 11 cooled by a cooling unit 13 which is also cooled by coolant flowing through a plurality of pipes 12 passing through the cooling unit 13. The cooling unit 13 has a recessed portion into which the metal block 11 is inserted, pushing against a coil spring 14. The metal block 11 has high heat conductivity and a smooth surface for making good contact with an inner wall surface of the recessed portion. The coil spring 14 is used to allow the metal block 11 to be placed in sufficient contact with the semiconductor device 10, with uniform pressure. The heat generated by the semiconductor device 10 is transferred to the cooling unit 13 through the metal block 11. Heat resistance at gaps between the semiconductor device 10 and the metal block 11 and between the metal block 11 and the inner wall surface of the cooling unit 13 is reduced by using gas, such as helium, having good heat conduction, to fill the gaps and a space 20.

Many kinds of liquid cooling unit have been proposed, but the presence of considerable heat resistance between semiconductor device and liquid cooling unit is a persistent problem. In efforts to mitigate this problem, the following proposals have been made for reducing this heat resistance:
(1) depositing soft metal (for example indium or an indium alloy) into a contact portion intended to be thermally contacted, under pressure;
(2) providing a liquid metal (for example mercury) at the contact portion;
(3) soldering the contact portion.

With (1) it is difficult to obtain high thermal conductivity because air layers always exist at gaps appearing at contact portions. With (2) there is always the fear of occurrence of short circuits caused by flow of liquid metal. With (3) stresses due to differences in thermal expansion between the solder, the semiconductor device and the liquid cooling unit can occur, so that the connecting structure around the contact portion is readily cracked when operation and cooling are frequently performed.

Thus, liquid cooling is effective for cooling a semiconductor device, compared with air cooling, but suffers a problem in that a sufficient cooling effect is difficult to obtain because of large heat resistance manifest between the semiconductor device and the cooling unit.

Patent Abstracts of Japan, Vol. 8, No. 36 (E-227) [1473], 16th February 1984, discloses the use of a metallic piece of low melting point, for example of Bi-Sn-In base alloy, located between a chip and a thermally conductive cap. The melting point or fusion starting temperature of the metallic piece is approximately the heating temperature of the chip.

According to the present invention there is provided a heat transfer medium, for heat transfer between an object, for example a semiconductor device, and a cooling unit,
characterised in that
the heat transfer medium has a composition such that it is a mixture of solid and liquid phases of one metal sherbet of a binary, ternary or multinary system at the normal operating temperature,
and in that
the heat transfer medium has a coefficient of viscosity more than 3000 Mpa.s at a temperature less than 40°C.

An embodiment of the invention can provide for improved cooling of a semiconductor device such as an LSI or a VLSI device.

An embodiment of the present invention can contribute to the realisation of an increase in packing density of semiconductor devices, for realising further development of semiconductor devices.

An embodiment of the present invention can contribute to the realisation of higher operating reliability of semiconductor devices.

Embodiments of the present invention can be applied to the cooling of objects other than semiconductor devices, particularly objects which for their size (surface area) develop considerable amounts of heat to be removed.

In an embodiment of the present invention a "metal sherbet" (or metal sorbet) is used for a heat conducting body between a cooling unit and an object to be cooled, for example a semiconductor device. The metal sherbet is metal being in the state of a mixture of a solid phase and a liquid phase, such as a mixture consisting of indium (In) and gallium (Ga).

In the, for example, binary system of Ga and In, when the weight percent of In is in a particular range, a two-phase mixture exists in the state of a highly viscous sherbet in which solids are dispersed in a liquid. In embodiments of the present invention, such a two-phase mixture is used as a heat conducting body.

By applying the metal sherbet to a heat conducting body, a sufficient thermal contact between, for example, a semiconductor device and a cooling unit can be realised without using so much (contact) pressure, and very high cooling efficiency can be obtained, because the heat conductivity of the metal sherbet is excellent. That is, heat resistance of the previous proposal in which silicon rubber is used (2.5°C/Watt), can be improved by half by applying an embodiment of the present invention.

In an embodiment of the present invention, a metal sherbet, consisting of metal in a state of a mixed phase of a liquid phase and a solid phase, is used as heat conducting body between a cooling unit and, for example, a semiconductor device for transferring heat generated by the semiconductor device to the cooling unit with high efficiency.

Reference is made, by way of example, to the accompanying drawings, in which :-
Fig. 1 is a schematic sectional view illustrating a previously proposed liquid cooling unit for a flat package type semiconductor device;
Fig. 2 is a schematic sectional view illustrating a previously proposed liquid cooling unit for a flip chip type semiconductor device;
Fig. 3(a) is a phase diagram of an In-Ga binary system, for assistance in explanation of an embodiment of the present invention;
Fig. 3(b) is a phase diagram of a Ga-Sn binary system, for assistance in explanation of an embodiment of the present invention;
Fig. 4 is a graph indicating the relationship between weight percent of In and viscosity, in an In-Ga binary system, for assistance in explanation of an embodiment of the present invention;
Fig. 5(a) is a sectional view of a flip chip type semiconductor device cooling arrangement using a metal sherbet in accordance with an embodiment of the present invention; and
Fig. 5(b) is a sectional view of a flat package type semiconductor device cooling arrangement using a metal sherbet in accordance with an embodiment of the present invention.

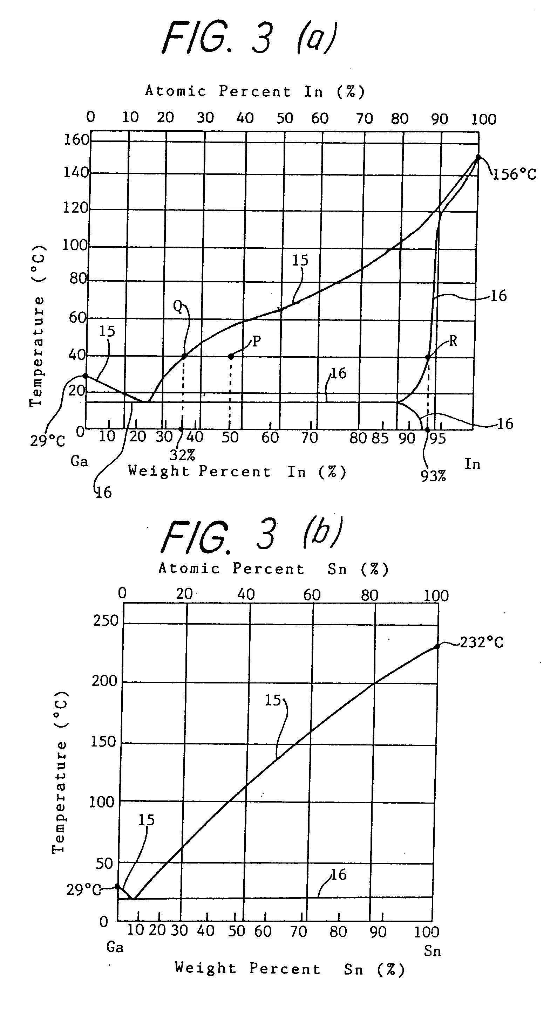

As indicated in the phase diagram of Fig. 3(a), for an In-Ga binary system, the melting point of In is approximately 156°C whilst the melting point of Ga is approximately 29°C. In this system, a phase mixture, related to an embodiment of the present invention, of a liquid phase and a solid phase lies within the range 24.5% - 88% (weight percent) or 16.3% - 81.7% (atomic percent) of In. The mixed phase region, referred to in this disclosure as a "metal sherbet" (or metal sorbet), corresponds to a region enclosed by a liquidus line 15 and a solidus line 16. For instance, when the In-Ga binary system includes 50 weight percent In and the temperature of the system is 40°C, a point P is obtained in the sherbet region, and points Q and R are obtained respectively by intersecting the X coordinate of 40°C with the lines 15 and 16. The point P then indicates the total composition, R indicates the composition of an In-Ga solid solution (which will be called simply "solid solution" hereinafter) and Q indicates the composition of an In and Ga liquid. From such points P, Q and R it can be said that the ratio of solid to liquid components in this system is equal to the ratio of the length P-Q to the length P-R. At the normal operating temperature of a semiconductor device, with normal cooling, the metal sherbet is in a state in which the In-Ga solid solution is dispersed in an In and Ga liquid. The ratio of the In-Ga solid solution to the In and Ga liquid depends on the ratio of In to Ga and the temperature of the In-Ga binary system, and the ratio of In to Ga in the In-Ga solid solution depends on the temperature. For instance, in Fig. 3(a), when the In weight percent decreases, the amount of dispersed In-Ga solid solution decreases, in other words the amount of In and Ga liquid increases.

Considering the temperature rise of a semi conductor device which operates normally under a normally cooled condition, a temperature range from 40°C to 90°C is enough to obtain a metal sherbet in the In-Ga binary system. Incidentally, in Fig 3(a), the 40°C line intersects the lines 15 and 16 at the points P and Q respectively as mentioned above, and the In weight percent at the point Q is 32% and that at the point R is 93%.

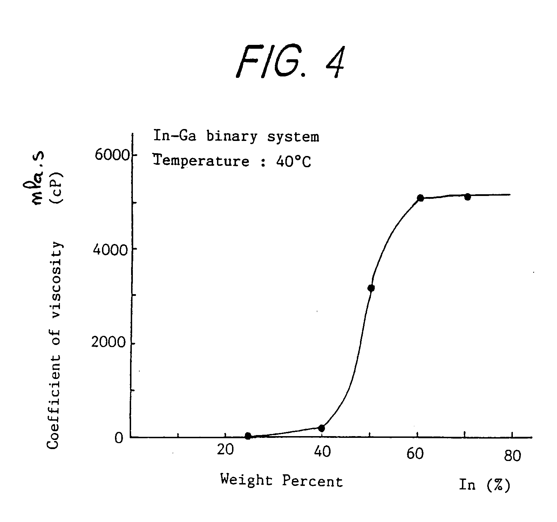

Fig. 4 shows the relationship between the In weight percent and viscosity (unit: millipascal seconds or mPa.s, equivalent to centipoise or cP) in the In-Ga binary system at the temperature of 40°C; the viscosity being measured by a B type viscosimeter. From this Figure, it will be understood that the viscosity is 3000 mPa.s (cP) or more when more than 50% weight percent of In is included in the In-Ga binary system.

In the context of embodiments of the present invention, it is preferable, in general, that the viscosity of the metal sherbet is more than 3000 mPa.s to avoid the metal sherbet flying out due to, for example, mechanical vibration.

Generally, the temperature of a semiconductor device rises more than 40°C in normal operation, so that, as shown in Fig. 4, the weight percent of In should be more than 50 in order to obtain a viscosity of more than 3000 mPa.s (cP). At the same time, since the maximum allowable temperature of the semiconductor device is approximately 80°C in operation, the weight percent of In must be less than 94, as shown in Fig. 4 (Fig. 3(a)). From the above, in order to form the mixture of the In-Ga solid solution and the In and Ga liquid, it can be said that (for normal semiconductor device applications) the proportion of In in the In-Ga binary system should be in the range 50 to 94 weight percent.

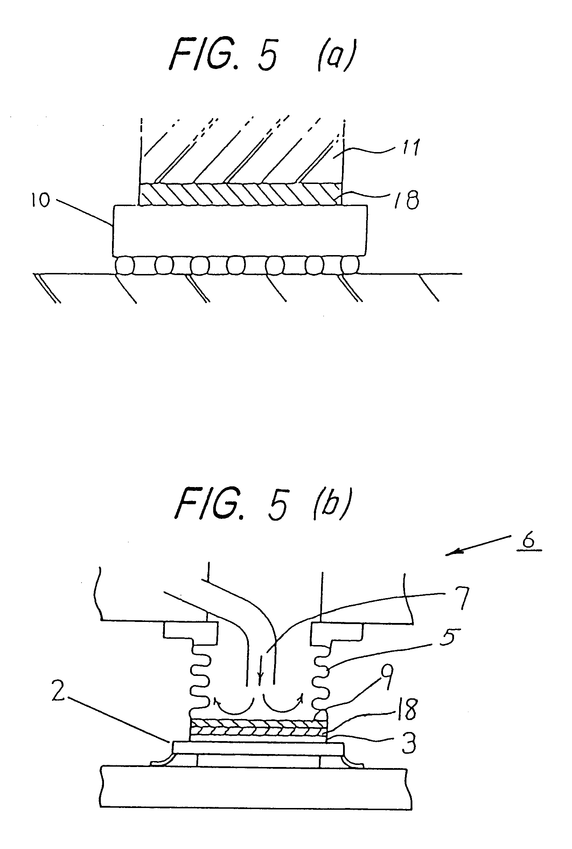

Fig. 5(a) is a schematic sectional view of a cooling structure for a flip chip type semiconductor device using a metal sherbet in accordance with an embodiment of the present invention as a heat conducting body. The structure of Fig. 5(a) corresponds otherwise to the structure of Fig. 2: like reference signs designate the same or similar items.

In Fig. 5(a), the semiconductor device 10 and the metal block 11 are thermally connected through a metal sherbet 18 having a high viscosity at a temperature obtained in normal operation of the semiconductor device 10 and the cooling unit 11. In this embodiment the In-Ga binary system having 80% weight percent of In is used as the metal sherbet. The above In-Ga binary system shows a two-phase (solid and liquid phase) mixture in the temperature range 15.7°C to 88°C. Using this metal sherbet 18 as the heat conducting body, a sufficient thermal connection can be obtained and no fear of short circuit due to lowered viscosity of the heat conducting body occurs, and, furthermore, resistance to heat transfer can be reduced in the same way as by soldering.

Fig. 5(b) is a schematic sectional view of an arrangement in which a flat package type semiconductor device 2 is cooled by a liquid cooling unit 6 connected to the device 2 using a metal sherbet 18 as heat conducting body in accordance with an embodiment of the present invention. The arrangement corresponds otherwise to that of Fig. 1, and like reference signs indicate the same or similar items.

In Fig. 5(b) the connection between the heat transfer plate 3 attached to the flat package type semiconductor device 2 and the heat conducting plate 9 of the liquid cooling unit 6 having bellows 5 is realised by using a metal sherbet 18 having a high viscosity at the operating temperature of the semiconductor device 2. The heat connection between the heat transfer plate 3 and the heat conducting plate 9 by the metal sherbet can be effected as stated in the explanation referring to Fig. 5(a), so that there is no fear of short circuit due to flowing of and leakage from a heat conducting body having a low viscosity, and resistance to heat transfer can also be reduced.

In the arrangements of Figs. 5, as in other embodiments of the present invention, a Ga-Sn binary system can be used to provide the heat conducting body. In the Ga-Sn binary system, when the weight percent of Sn is 20% - 60% similar effects to those obtained with the In-Ga binary system can be achieved.

Fig. 3(b) is a phase diagram of the Ga-Sn binary system. As indicated in the Figure, the melting point of Sn is approximately 232°C and the melting point of Ga is approximately 29°C. In Fig. 3(b), the region enclosed by the liquidus line 15 and the solidus line 16 is a metal sherbet region. In this region, the Ga-Sn solid solution solids (which will be called "Ga-Sn solid solution" hereinafter) are dispersed in a Ga and Sn liquid so that the ratio of the Ga-Sn solid solution to the Ga and Sn liquid and the composition ratio of Ga to Sn depend on the component ratio of Ga to Sn in the metal sherbet and the temperature of the metal sherbet.

The relationship between weight percent of Sn and viscosity, measured by a B type viscosimeter, in the Ga-Sn binary system can be obtained similarly to that for the In-Ga binary system as shown in Fig. 4. When the weight percent of Sn is 20% - 60% (more desirably 30% - 45%) and that of Ga is 80% - 40% (more desirably 70% - 55%), the same effect can be obtained as in the case of the In-Ga binary system. That is, if the weight percent of Sn is less than 20%, the temperature range for the Ga-Sn binary system to be in the state of the phase mixture becomes narrow, and if the weight percent is more than 60%, the viscosity of the Ga-Sn binary system (metal sherbet) becomes so large that it would be difficult to form the metal sherbet so as to uniformly attach to the metal block 11 and the semiconductor device 10, in the case of use for cooling the flip chip type semiconductor device 10 as shown in Fig. 5(a), or to the heat transfer plate 3 and the heat conducting plate 9 in the case of use for cooling the flat package type semiconductor device as shown in Fig. 5(b).

In each of the phase diagrams (Figs. 3(a) and 3(b)), it is preferable that the temperature difference between the liquidus line and the solidus line is large, because the usage temperature range for the heat conducting body can then be widened.

In Figs. 5(a) and 5(b) the metal sherbet for the heat conducting body is formed by the following steps, when, for example, the In-Ga binary system is applied to the heat conducting body 18 :-
(1) providing a first In-Ga solid solution having, for example, 75.5% (weight) of Ga and 24.5% (weight) of In; wherein the first In-Ga solid solution is in a liquid phase at room temperature;
(2) wetting the surfaces, to be connected, of the semiconductor device and the cooling unit with the first In-Ga solid solution;
(3) providing a second In-Ga solid solution which is in the state of a phase mixture when its temperature rises to, for example, 40°C (the temperature e.g. 40°C being decided by considering the cooling conditions to be provided for the object to be cooled e.g. the semiconductor device);
(4) putting the semiconductor device and the cooling unit in an atmosphere having a temperature of 40°C;
(5) dropping a proper amount of the second In-Ga solid solution on the wet surfaces of the semiconductor device and the cooling unit, so that the In-Ga solid solution dropped on is naturally spread over the surfaces;
(6) connecting the surfaces to each other;
(7) taking the semiconductor device and the cooling unit out of the said atmosphere into normal atmosphere at room temperature.

Although the use of the In-Ga and Ga-Sn binary systems for providing the metal sherbet is described above, multinary systems, such as ternary systems substantially including respectively In and Ga or Ga and Sn, can also be used for providing the metal sherbet.

Embodiments of the present invention can be applied not only in the contexts of flip chip and flat package semiconductor devices but also to other types of semiconductor device and to other objects or devices. Embodiments of the present invention can be applied in the contexts of liquid cooling systems other than those described using liquid cooling units or structures.

In some circumstances, embodiments of the present invention can be applied for the purpose of transferring heat to an object from a heating system.

An embodiment of the present invention involves a heat transfer medium having a composition such that it is in the form of a phase mixture of solid and liquid phases at the appropriate temperature. The phases may be a solid solution and a liquid mixture of two or more components, providing the medium as a metal sherbet. For instance, in an In-Ga binary system solids of In-Ga solid solution are dispersed in an In and Ga liquid. The medium may be placed between a cooling unit and an object, e.g. a semiconductor device, to be cooled, exhibiting the solid and liquid phase mixture form at the normal operating temperature of the device and cooling unit.

## Claims

1. A heat transfer medium (18), for heat transfer between an object (10), for example a semiconductor device, and a cooling unit (11),
characterised in that
the heat transfer medium (18) has a composition such that it is a mixture of solid and liquid phases of one metal sherbet of a binary, ternary or multinary system at the normal operating temperature,
and in that
the heat transfer medium has a coefficient of viscosity more than 3000 mPa.s at a temperature less than 40°C.

2. A heat transfer medium as claimed in claim 1, being a mixture comprising 50 to 94 weight percent indium and the balance gallium.

3. A heat transfer medium as claimed in claim 1, being a mixture comprising 20 to 60 weight percent tin and the balance gallium.

4. Use of a heat transfer medium as claimed in claim 1, 2 or 3, for heat transfer between an object (10), for example a semiconductor device, and a cooling unit (11).

## Patentansprüche

1. Wärmeübertragungsmedium (18) zur Wärmeübertragung zwischen einem Objekt (10), beispielsweise einer Halbleiteranordnung, und einer Kühleinheit (11),
dadurch gekennzeichnet, daß das Wärmeübertragungsmedium (18) eine derartige Zusammensetzung aufweist, daß es eine Mischung von festen und flüssigen Phasen eines Metallsherbets eines binären, ternären oder multinären Systems bei der normalen Betriebstemperatur ist,
und dadurch, daß
das Wärmeübertragungsmedium einen Viskositätskoeffizienten von mehr als 3000 mPa.s bei einer Temperatur von weniger als 40°C aufweist.

2. Wärmeübertragungsmedium nach Anspruch 1, welches eine Mischung ist, die 50 bis 94 Gewichtsprozent Indium und als Ausgleich Gallium umfaßt.

3. Wärmeübertragungsmedium nach Anspruch 1, welches eine Mischung ist, die 20 bis 60 Gewichtsprozent Zinn und als Ausgleich Gallium umfaßt.

4. Verwendung eines Wärmeübertragungsmediums nach Anspruch 1, 2 oder 3, zur Wärmeübertragung zwischen einem Objekt (10), beispielsweise einer Halbleiteranordnung, und einer Kühleinheit (11).

## Revendications

1. Milieu de transfert thermique (18) pour transférer de la chaleur entre un objet (10), par exemple un dispositif à semiconducteur, et une unité de refroidisssement (11),
caractérisé en ce que :
le milieu de transfert thermique (18) présente une composition qui est un mélange de phases solide et liquide d'un sorbet de métal d'un système binaire, ternaire ou multinaire à la température de fonctionnement normale ; et
en ce que :
le milieu de transfert thermique présente un coefficient de viscosité supérieur à 3000 mPa.s à une température inférieure à 40°C.

2. Milieu de transfert thermique selon la revendication 1, ce milieu étant un mélange comprenant 50 à 94 % par unité de poids d'indium et le complément de gallium.

3. Milieu de transfert thermique selon la revendication 1, ce milieu étant un mélange comprenant 20 à 60 % par unité de poids d'étain et le complément de gallium.

4. Utilisation d'un milieu de transfert thermique selon la revendication 1, 2 ou 3, pour un transfert thermique entre un objet (10), par exemple un dispositif à semiconducteur, et une unité de refroidissement (11).
